(19) Europäisches Patentamt

European Patent Office

Office européen des brevets

(11) **EP 0 985 976 A2**

(12) **EUROPEAN PATENT APPLICATION**

(43) Date of publication:
**15.03.2000 Bulletin 2000/11**

(51) Int. Cl.⁷: **G03F 7/20**

(21) Application number: **99117735.3**

(22) Date of filing: **08.09.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **08.09.1998 JP 26905698**

(71) Applicant: **NIKON CORPORATION Tokyo (JP)**

(72) Inventors:
• **Komatsuda, Hideki,
c/o Nikon Corp.
Chiyoda-ku, Tokyo (JP)**
• **Mori, Takashi,
c/o Nikon Co.
Tokyo (JP)**

(74) Representative:
**Viering, Jentschura & Partner
Postfach 22 14 43
80504 München (DE)**

(54) **Illumination apparatus, projection exposure apparatus and projection exposure method**

(57)   Projection exposure apparatus and method, and illumination optical system thereof. A reflection mask on which a predetermined pattern is formed is illuminated by an illumination optical system directing with radiation light from a light source.

A projection optical system directs the radiation light reflected by said reflection mask to an exposed substrate (work) for forming an image of a predetermined pattern on said exposed substrate, wherein a scanning driver relatively moves at least one of said reflection mask and said exposed substrate, and said illumination optical system includes a field stop located close by a position conjugate with said reflection mask.

*Fig. 1*

## Description

## Background of the invention

### Field of the Invention

The invention relates to a projection exposure apparatus and its method used in the lithography process of projecting a form, such as mask or reticle, to a wafer for fabricating devices, e.g. integrated circuit, imaging device, liquid crystal display, or thin film magnetic recording head. More specifically, the present invention relates a projection exposure apparatus and its method using soft x-ray called EUVL (Extreme Ultra Violet Lithography). Moreover, the present invention relates an illumination optical system and its method suitable for the projection exposure apparatus. Furthermore, the present invention relates fabrication method for said devices by means of said apparatus or said method thereof.

### Back Ground of the Invention

A projection exposure apparatus for projecting form, such as mask and reticle, to wafer by means of soft x-ray (EUV radiation) is disclosed in the documents such as Sweatt, William C. *High-Efficiency Condenser Design for Illuminating a Ring Field*. OSA Proceedings on Soft X-Ray Projection Lithography, Vol. 18 (1993) and U.S. Pat. No. 5,315,629.

In these projection exposure apparatus, a reflection type mask is used as a form, and the exposure is performed while the form is being moved relative to the projection optics. In other words, a scanning exposure method is utilized for projecting whole pattern of the form to the shot area on the work. The method is performing exposure while an exposure area, which is an image of a portion of the form, is being scanned on the work.

In the projection exposure apparatus using soft x-ray according to prior art described above, the exposure area should be limited in order only for the specific pattern on the mask to perform exposure.

In performing scanning exposure, in order to make cumulative exposure equal at any point in the shot area, the slit width along to scanning direction within the exposure area is necessary to make substantially equal at any point along to the direction perpendicular to the scanning direction.

In performing scanning exposure, there are two methods for limiting the exposure area that a slit is placed near the reflection mask and that a slit is placed near the work. In former method, the slit must be moved relative to the reflection mask while performing exposure. In latter method, on the other hand, the slit must be moved relative to the work while performing exposure. Therefore, there must be some space between the slit and the reflection mask, or the work, in order to avoid direct contact between the slit and the reflection mask, or the work.

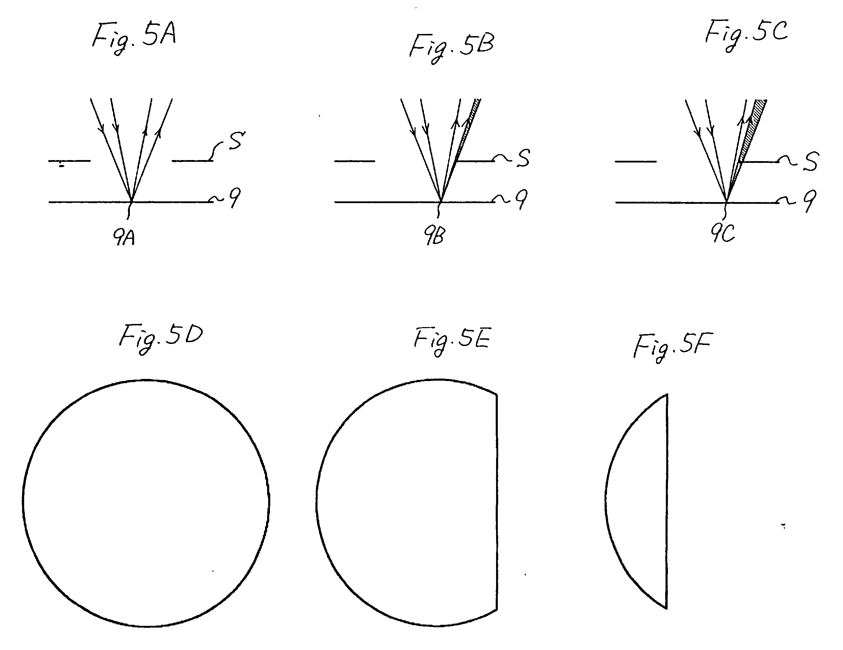

In this way, the case where the distance between the slit and the reflection mask, or the slit and the work is set to be apart is described with reference to Fig. 5. Figs. 5A through 5C show the relation between the slit S and the light flux arriving at the reflection mask 9. Fig. 5A shows the case where the light flux is arriving at the center 9A of the exposure area. Figs. 5B and 5C show the cases where the light flux are arriving at the corners 9B, 9C of the exposure area. Since the light flux arriving at the center of the exposure area does not produce vignetting, as seen from Fig. 5A, the shape of the aperture of the projection optical system becomes circle as shown in Fig, 5D. Because the light flux arriving at 9B, 9C, on the other hand, produce vignetting as seen by the hatched portion in Figs. 5B, 5C, the shape of the aperture of the projection optical system shows that a portion of a circle is cut out, as seen in Figs. 5E, 5F.

The resolving power of an optical system is generally represented by the following equation:

$$LW = k \cdot \lambda/NA.$$

Wherein the reference symbol LW represents the line width at the resolution limit, k represents a constant, $\lambda$ represents the wavelength, and NA represents the numerical aperture of the projection optical system. As seen from the upper equation, the line width at the resolution limit is inversely proportional to the numerical aperture of the projection optical system. It is required that the resolving power should be constant regardless of the position in the wafer plane or direction of pattern (vertical, horizontal or inclined).

If the slit S is placed near the reflection mask, or near the work, the vignetting is produced in a portion of the light flux at exposure area near the edge of the slit S. Since the resolving power varies in accordance with the direction of the pattern, it is no more possible to get good image. In scanning exposure method, since the scanning exposure is performed including the area where not good image is formed, there is a problem that the image of whole illumination area becomes worse.

If you want to change the magnitude or shape of the exposure area or illumination area, it will be needed for the slit itself to be movable. In this case, it is impossible to project good image because of such problems as described below. In order to prevent interference between the movable mechanism of the slit S and the reflection mask, or the work, the distance between the slit S and the reflection mask, or between the slit S and the work, becomes apart. And also dust is produced from the movable mechanism of the slit S.

## Summary of the Invention

Accordingly, it is an object of the present invention to provide a good image even in such a case when a reflection mask is used.

In order to achieve above described object, a projection exposure apparatus according to an embodiment of the present invention is:

a light source providing radiation light;
an illumination optical system directing said radiation light to a reflection mask on which a predetermined pattern is formed;
a projection optical system directing said radiation light reflected by said reflection mask to an exposed substrate (work) for forming an image of a predetermined pattern on said exposed substrate; and
a scanning driver relatively moving at least one of said reflection mask and said exposed substrate;
wherein said illumination optical system includes a field stop located close by a position substantially conjugate with said reflection mask.

And in order to achieve above described object, a projection exposure apparatus according to another embodiment of the present invention is:

for directing radiation light to a reflection mask on which a predetermined pattern is formed, and for projecting an image of said predetermined pattern on a work by said radiation light reflected by said reflection mask, the projection exposure apparatus comprising:

a radiation light source;
an illumination optical system located between said radiation light source and said reflection mask, and directing said radiation light provided from said radiation light source to said reflection mask;
a projection optical system located between said reflection mask and said work, directing said radiation light reflected by said reflection mask to an exposed substrate, and forming the image of said predetermined pattern on said exposed substrate;
a scanning driver relatively changing positional relationship between at least one of said reflection mask and said work, and said projection optical system; and
a field stop located close by a position conjugate with said reflection mask.

In order to achieve above described object, an illumination apparatus according to another embodiment of the present invention is:

for using in a photolithography apparatus forming an image of a reflection mask, on which a predetermined pattern is formed, on a work, the illumination apparatus comprising:

a radiation light source; and
an illumination optical system located between said radiation light source and said reflection mask, and for directing said radiation light provided from said radiation light source to predetermined illumination area on said reflection mask;
wherein said illumination optical system includes a field stop and a relay optical system forming an image of said field stop on said reflection mask as said predetermined illumination area.

In the embodiments described above, it is desirable for said relay optical system to be catoptric system. In any embodiment described above, it is desirable for said radiation source to provide radiation light having wavelength shorter than 50 nm.

And in order to achieve above described object, a projection exposure apparatus according to another embodiment of the present invention is:

for directing radiation light to a reflection mask on which a predetermined pattern is formed, and for projecting an image of said predetermined pattern on a work by said radiation light reflected by said reflection mask, the projection exposure apparatus comprising:

a radiation light source;
an illumination optical system located between said radiation light source and said reflection mask, and directing said radiation light provided from said radiation light source to said reflection mask;
a projection optical system located between said reflection mask and said work, directing said radiation light reflected by said reflection mask to an exposed substrate, and forming the image of said predetermined pattern on said exposed substrate;
wherein a position of at least one of reflection optical elements located along to the optical path of said radiation light in said illumination optical system is adjustable in order to adjust illuminance distribution of said radiation light on said exposure area.

And in order to achieve above described object, a projection exposure method according to another embodiment of the present invention is that a method of projecting and exposing a predetermined pattern formed on a reflection mask onto a work comprising the steps of:

providing a radiation light source;
illuminating a reflection mask on which a predetermined pattern is formed with said radiation light source by means of an illumination optical system;

projecting said pattern of said reflection mask onto a work based on reflected light from said reflection mask; and

relatively moving at least one of said reflection mask and said work each other;

wherein said illuminating step further comprising a step of forming an image of a field stop placed in said illumination optical system on said reflection mask.

And in order to achieve above described object, a projection exposure method according to another embodiment of the present invention is a method of projecting and exposing a predetermined pattern formed on a reflection mask onto a work comprising the steps of:

providing a radiation light source;

illuminating a reflection mask on which a predetermined pattern is formed with said radiation light source by means of an illumination optical system;

projecting said pattern of said reflection mask onto a work based on reflected light from said reflection mask;

adjusting a position of at least one optical element located along the optical path where said radiation light is directed to said field stop in order to change illuminance distribution in said exposure area on said work.

In the present invention, by the way, radiation light means an electromagnetic wave including deep ultraviolet area, vacuum ultraviolet area, soft x-ray area, and hard x-ray area.

## Brief Description of Drawings

Fig. 1 represents the schematic diagram showing the optical design of the projection exposure apparatus according to the present invention.

Fig. 2 represents the schematic diagram showing the state of the scanning exposure.

Fig. 3 represents the schematic diagram showing the mechanism of the field stop according to the modification of the present invention, Fig. 3A shows its sectional view, and Fig. 3B shows its plan view.

Fig. 4 represents the schematic diagram showing the movement of the field stop shown in Fig. 3. Figs. 4A through 4E represent the plan view showing the relative position between the fixed field stop and the movable field stop. Figs. 4F through 4J represents the plan view showing relative position between the shot area and the exposure area on the wafer.

Fig. 5 represents the schematic diagram showing the problems in a projection exposure apparatus according to prior art. Figs. 5A through 5C represent the plan views showing the vignetting of the light flux caused by a field stop. Figs. 5D through 5F represent the schematic diagrams showing the shape of the aperture produced by the vignetting of the light flux.

## Detailed Description of Preferred Embodiments

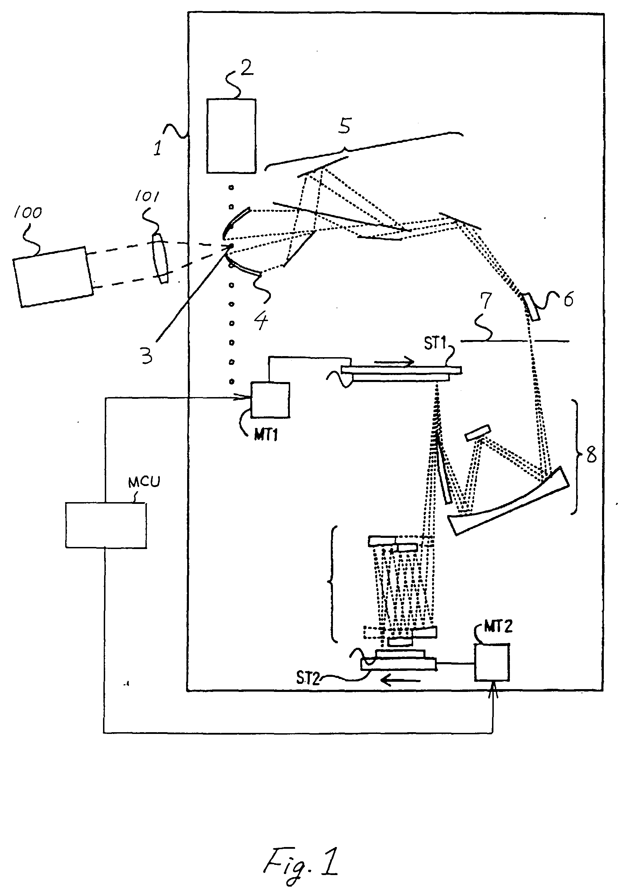

The present invention will be described in detail blow in accordance with the embodiment shown in Fig. 1. A laser source 100 generates laser light having wavelength from infrared region to visible light region. YAG laser, for example, can be used for the laser source 100. Laser light generated by the laser source 100 is converged by a collecting optics 101 focusing at a focal point 3. An object (EUV light-generating object) dripped from a object source 2 is illuminated with high illuminance laser light at the focal point 3. The central portion of the object thereby becomes plasma, and then soft x-ray is generated from here. The following objects can be used for the EUV light-generating object (target) such as water drop, ice particle, a drop of any kind of water solution, Xe gas, Kr gas, or tape or wire shaped Cu or Ta (Tantalum).

As for the wavelength of the soft x-ray, it is desirable to use wavelength smaller than 50 nm, e.g. a radiation light source of 13 nm. Since the transmittance of soft x-ray relative to air is rather low, whole apparatus is placed in a vacuum chamber 1.

The soft x-ray generated at focal point 3 is directed to a field stop(aperture) 7, having an opening of a predetermined area, by the optics 4, 5, and 6, which is a combination of plane mirrors and concave mirrors. In this embodiment, a reflection-increase film, increasing the reflectance in the soft x-ray region, is coated on the reflecting surface of the optics 4, 5, and 6. As for the reflection-increase film, the following combination of materials can be used, such as Mo and Si or Mo and Be, which are alternately coated by several tens of layers.

As for the field stop 7, materials blocking soft x-ray are suitable for this purpose.

In this embodiment, although a laser plasma x-ray source is used for the light source, an undulator equipped in a synchrotron orbital radiation (SOR) can be used for the light source. In this embodiment, although the wavelength of 13 nm generated from SOR is used, the wavelength such as 26 nm and 39 nm generated from SOR as well as 1 nm of hard x-ray can also be used.

Then, the radiation light passed through the opening of the field stop 7 is directed to a reflection mask 9 through a relay optical system 8 consisting of reflection optics. A pattern consisting of a portion reflecting soft x-ray and a portion not reflecting soft x-ray is formed on the surface of the reflection mask 9. The optical systems 4, 5, 6, and 8 compose an illumination optical system illuminating the reflection mask 9.

The field stop 7 is optically conjugate with the reflection mask 9 with respect to the relay optical system 8, and an image of the field stop 7 is projected on the reflection mask 9. The image of the opening of the field stop 7 coincides with the illuminated area on the reflection mask 9.

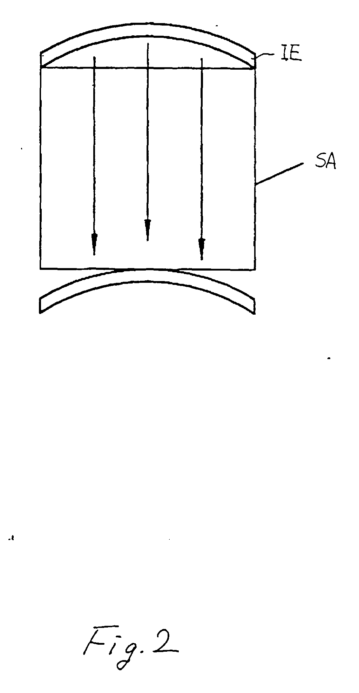

The radiation light selectively reflected by the reflection mask 9 is directed to a wafer 11, as a exposed substrate (work), placed on a substrate sage ST2 by a projection optical system 10 having predetermined reduction magnification. And then the pattern in the illuminated area on the reflection mask 9 is projected on the wafer 11. As shown in Fig. 2, an exposure area IE is formed on the wafer 11. The exposure area IE has similar shape to the illuminated area on the reflection mask 9 that is similar to the opening of the field stop 7. The image of the pattern in the illuminated area on the reflection mask 9 is formed in the exposure area IE.

Going back to Fig. 1, a mask stage ST1 and the substrate stage ST2 are connected with drivers MT1 and MT2 respectively. These drivers MT1 and MT2 are connected with a main controller MCU.

While performing exposure, the reflection mask 9 and wafer (exposed substrate) 11 are moved relative to the projection optical system 10 in the direction indicated by an arrow shown in Fig. 1 by means of these driver MT1 and MT2. In this embodiment, since inside of the chamber 1 is vacuum, it is desirable to use magnetic levitation type linear actuator or differential exhaust type pneumatic bearing in combination with an actuator such as linear motor by way of these driver MT1 and MT2. It is also desirable to use electrostatic chuck by way of chucking mechanism in the mask stage ST1 and in the substrate stage ST2.

As shown in Fig. 2, the exposure area IE is swept along the scanning direction, indicated by the arrow in the figure, on the wafer 11 as a work (exposed substrate). The exposure area on the wafer 11 is consequently corresponding with the locus of the sweep of the exposure area IE, and the exposure area is corresponding with single shot area SA on the wafer 11.

In this embodiment, the field stop 7 is optically conjugate with the reflection mask 9 with respect to the relay optical system 8. The field stop 7 is optically conjugate with the wafer 11 with respect to the relay optical system 8, the reflection mask 9 and the projection optical system 10. Since it is optically equivalent to placing the field stop 7 on the reflection mask 9, the illuminated area (or the exposure area) can be limited. In this configuration, because of no field stop 7 existing in the vicinity of the reflection mask 9, there is no vignetting produced by the field stop 7 at any point in the exposure area, and good resolution can be obtained in the whole exposure area.

If an intermediate image of the reflection mask 9 is formed in the projection optical system 10, the field stop 7 can be placed at the intermediate image position.

It is desirable to compose the projection optical system 10 with such a reflection optical system having less than six reflection surfaces.

Although only one field stop 7 is used in this embodiment shown in Fig. 1, field stop is not limited to one. It is possible to compose with plural element such as blades limiting the width in the direction perpendicular to the sweeping direction together with blades limiting the width in the sweeping direction.

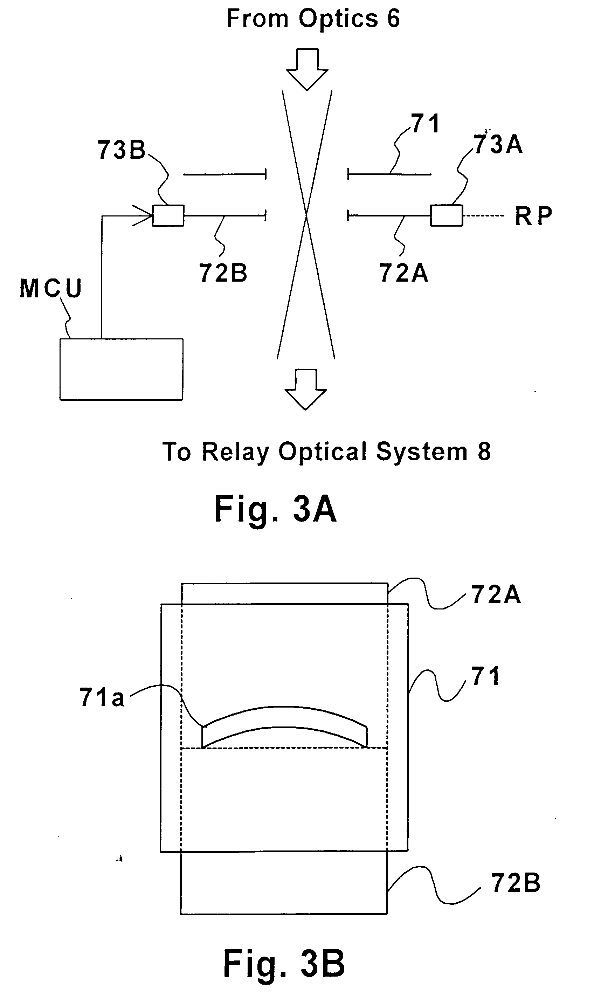

A modified example of the field stop is described with reference to Fig. 3. Fig. 3A represents a sectional view showing a field stop 70 consisting of a fixed field stop 71 and variable field stops 72A and 72B. Fig. 3B represents a plan view showing the relative position of the fixed field stop 71 and the variable field stops 72A and 72B.

In Figs. 3A, 3B, the field stop has the fixed field stop 71 and the movable field stop (72A, 72B). Wherein the field stop is having an arc shaped opening 71a and the movable field stop is having two blades 72A, 72B defining the width in the sweeping direction of the illumination area (or exposure area) on the reflection mask 9 (or on the wafer 11). By the way, the fixed field stop 71 shown in Figs. 3A, 3B is equivalent to the field stop 7 in Fig. 1.

Each blade 72A, 72B defining the width in the sweeping direction of the movable field stop is movably held such that each blade 72A, 72B has a driving unit 73A, 73B driving each blade in the sweeping direction independently. Here, the sweeping direction is corresponding with the direction where the projected image of the reflection mask 9 (or the wafer 11) on the field stop 7 by the relay optical system 8 (or by the relay optical system 8 in combination with the projection optical system 10) is swept. In the modified embodiment shown in Fig. 3, the radiation light illuminates the predetermined area defined by the movable field stop 72A, 72B, which is within the scope of the arc shaped illumination area on the reflection mask 9 (or the wafer 11) defined by the fixed field stop 71.

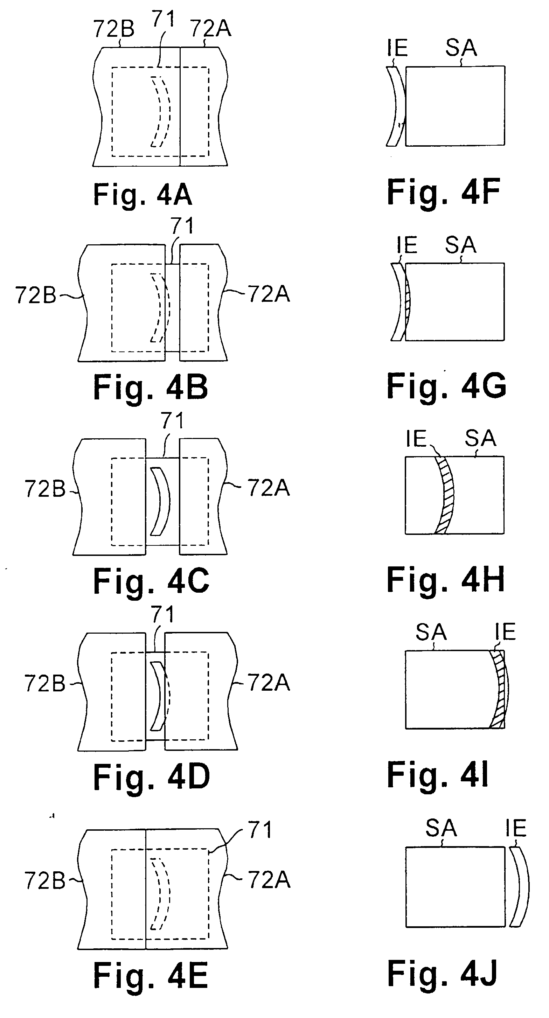

Said main controller MCU controls the movable blade-driving unit 73A, 73B. An example of control system will be described bellow with reference to Figs. 3, 4. Figs. 4A through 4E represent plan views showing the relative position between the opening of the fixed field stop 71 and the blades 72A, 72B of the movable field stop. Figs. 4F through 4J represent plan views showing the position of the exposure area IE relative to the single shot area on the wafer 11. Fig. 4F shows relative position between the exposure area IE and the shot area SA where the position of the movable field stop is shown in Fig. 4A. In the same way, Fig. 4G corresponds to Fig. 4B, Fig. 4H to Fig. 4c, Fig. 4I to Fig. 4D, and Fig. 4J to Fig. 4E. By the way, in Figs. 4F through 4J showing the relative position between the shot area SA and exposure area IE, hatched area shows the area where the radiation light is really illuminating on the wafer 11.

The main controller MCU shown in Fig. 3 drives the mask stage ST1 and the substrate stage ST2 by means of the drivers MT1, MT2, and places the exposure area IE at the left side of the shot area SA shown in Fig. 4F. At this moment, since the blades 72A and 72B of the movable field stop are closed as shown in Fig. 4A, radiation light does not reach to the exposure area IE (the exposure area IE is not formed).

Then, the main controller MCU drives the mask stage ST1 and the substrate stage ST2 along to the sweeping direction with such velocities determined by the magnification of the projection optical system by means of the driving units MT1 and MT2. At the same time, the main controller MCU drives the blade 72B along to said sweeping direction by means of the movable blade-driving unit 73B. At this time, in order that the edge image of the blade 72B is substantially coincide with the edge of the shot area SA, the blade 72B is driven in accordance with the stages ST1 and ST2.

When the blades 72A and 72B are opened as shown in Fig. 4C, radiation light pass through the whole area of the opening of the fixed field stop 71. As a result, the exposure area IE according to the image of the opening of the fixed field stop 71 is formed in the shot area SA on the wafer 11 as shown in Fig. 4H. In this instance, since the stages ST1 and ST2 are still being driven along the sweeping direction, the exposure area IE sweeps the shot area SA. When the exposure area IE approaches the edge of the shot area SA as shown in Fig. 4I, the main controller MCU drives the blade 72A along the direction according to the sweeping direction by means of the movable blade driving unit 73A, as shown in Fig. 4D. Therefore, radiation light overflowed from the shot area SA, which is directed to the exposure area IE, is blocked by the blade 72A. At this moment, the blade 72A is driven in order for the image of the edge of the blade 72A to substantially coincide with the edge of the shot area SA in accordance with the stages ST1 and ST2.

Then, when the exposure area IE goes beyond the shot area SA as shown in Fig. 4J, the blades 72A and 72B are closed, and radiation light is no more directed to the exposure area IE (the exposure area IE is no more formed).

From a series of movements described above, the pattern on the reflection mask 9 is projected in a single shot area on the wafer 11. Then, the main controller MCU drives the substrate stage ST2 by means of the driving unit MT2, and the exposure area IE is placed to another shot area (typically next to the former shot area SA). Then, a series of movements described above is repeated.

Although the pattern is projected in single shot area with one stroke scanning exposure movement as described in Figs. 3 and 4, so called "scan and stitch exposure" can be used that the pattern is projected in single shot with multi stroke scanning exposure movement. When the scan and stitch exposure is used, since wide exposure area (in scanning direction) is not required to the projection optical system 10, it becomes easy to manufacture the projection optical system, or it has merit to improve imaging quality of the projection optical system. Suzuki discloses this type of scan and stitch exposure apparatus in the U.S. patent application 08/654,747 (May 29, 1996). Here, we refer the U.S. patent application 08/654,747.

In this embodiment shown in Fig. 1, it is possible to use an illumination optical system disclosed in the U.S. patent application 09/359,137 (February 26, 1999) by Komatsuda, one of the coinventor of the present invention. Here, we refer the U.S. patent application 09/359,137.

It is briefly explained that the case the U.S. patent application 09/359,137 is applied to the present invention. In the illumination optical system disclosed in the U.S. patent application 09/359,137, radiation light provided from light source 54 is directed to a reflection type optical integrator, and is forming second source having predetermined shape, and is illuminating mask M through a condenser optical system 64. It is possible to replace the optical system 4, 5, and 6 shown in Fig. 1 of the present invention with the illumination optical system (54,56, and 64). So that the illumination optical system (54,56, and 64) is used for illuminating the field stop 7, and the image of the field stop 7 is projected to the reflection mask 9 by the relay optical system 8 shown in Fig. 1.

The illuminance distribution on the reflection mask 9, or on the wafer 11, can be varied by adjusting position of at least one element of the optical elements consisting of the illumination optical system, or by inserting reflecting element having spatial distribution of reflectance into the illumination optical system. By means of varying the illuminance distribution on the reflection mask 9, or on the wafer 11 (exposed substrate as a work), it is possible to obtain uniform (or desired) illuminance distribution. In this case, it is desirable that the position of the optical element performing adjustment is located in the optical path between the field stop 7 and the radiation source.

In the illumination optical system shown in Fig. 1, it is possible to change distortion (isotropic or anisotropic) in the optical elements illuminating the field stop 7 by following procedure. That is, for example changing inclination of at least one of plane mirrors 5, or by changing the position along to the optical axis, or the position perpendicular to the optical axis of the concave mirror 6, or by changing the small amount of inclination of the concave mirror 6. As a result, the illuminance distribution on the field stop 7 can be varied, and, finally, the illuminance distribution on the reflection mask 9 or on the wafer 11 can be varied.

It will be liable to occur that while moving said at least one optical element, the optical property other than distortion (e.g. telecentricity) will change. In this case. moving the position of optical element(s) other than said at least one optical element can perform adjustment.

At this moment, it is not desirable because of the reason described below that an optical element between the field stop 7 and the reflection mask 9, which is an optical element consisting the relay optical system 8, is moved for adjustment of position. The reason is that it arises not only changing luminance distribution of radiation light but also changing shape of the opening of the field stop 7. On the other hand, there is no limitation of position where a reflecting element having spatial distribution of reflectance is inserted.

In the embodiment described above, although the case is described that an arc shaped illumination area is formed on the reflection mask 9, the present invention is not limited to the arc shape. If the projection optical system is made for forming rectangular shaped exposure area, the illumination optical system according to present invention can easily be modified to illuminate rectangular shaped area. To put it concretely, it is accomplished by modifying the shape of the opening of the field stop from arc shape to rectangular shape.

As for the projection optical system, it can be used the system having unit magnification and expansion magnification as well as reduction magnification. Also the present invention can be applied to proximity type scanning exposure apparatus such as x-ray exposure apparatus that a mask and a wafer are moved in a body relative to the arc shaped illumination area illuminated with x-ray radiation.

The present invention can be applied not only to the projection exposure apparatus for manufacturing semiconductor device but also to the projection exposure apparatus for manufacturing display device including liquid crystal display by projecting device pattern onto glass plate. And it can also be applied to the projection exposure apparatus for manufacturing thin film magnetic head by projecting device pattern onto ceramic wafer and to the projection exposure apparatus for manufacturing image detector (such as CCD). And the present invention can also be applied to the projection exposure apparatus for manufacturing a reticle or a mask by projecting device pattern onto glass substrate or silicon wafer.

The foregoing description of the embodiment has been presented for purpose of clarifying the technical contents of the present invention. It is not intended to limit the invention to the precise form disclosed. Obvious modifications or variations are possible in light of the above teachings. The embodiment was chosen and described to provide the best illustration of the principles of the invention and its practical application to thereby enable on of ordinary skill in the art to utilize the invention in various embodiments and with various modifications as are suited to the particular use contemplated.

## Claims

1. A projection exposure apparatus comprising:

   a light source providing radiation light;
   an illumination optical system directing said radiation light to a reflection mask on which a predetermined pattern is formed;
   a projection optical system directing said radiation light reflected by said reflection mask to an exposed substrate (work) for forming an image of a predetermined pattern on said exposed substrate; and
   a scanning driver relatively moving at least one of said reflection mask and said exposed substrate;
   wherein said illumination optical system includes a field stop located close by a position conjugate with said reflection mask.

2. A projection exposure apparatus according to claim 1,
   wherein said illumination optical system includes a relay optical system to make said field stop to be substantially conjugated with said reflection mask.

3. A projection exposure apparatus according to claim 2,
   wherein said relay optical system is a catoptric system.

4. A projection exposure apparatus according to claim 1,
   wherein said light source provides radiation light having wavelength shorter than 50 nm.

5. A projection exposure apparatus according to claim 1,
   wherein a position of at least one optical element located between said light source and said field stop is adjustable in order to change illuminance distribution on said reflection mask or on said work.

6. A projection exposure apparatus, for directing radiation light to a reflection mask on which a predetermined pattern is formed, and for projecting an image of said predetermined pattern on a work by said radiation light reflected by said reflection mask, the projection exposure apparatus comprising:

   a radiation light source;
   an illumination optical system located between said radiation light source and said reflection mask, and directing said radiation light provided from said radiation light source to said reflection mask;
   a projection optical system located between said reflection mask and said work, directing said radiation light reflected by said reflection mask to an exposed substrate, and forming the image of said predetermined pattern on said exposed substrate;

a scanning driver relatively changing positional relationship between at least one of said reflection mask and said work, and said projection optical system; and

a field stop located close by a position conjugate with said reflection mask.

7. A projection exposure apparatus according to claim 6,

wherein said field stop is located in said illumination optical system.

8. A projection exposure apparatus according to claim 7,

wherein said illumination optical system includes a relay optical system, located between said field stop and said reflection mask, projecting an image of said field stop on said reflection mask.

9. A projection exposure apparatus according to claim 6,

wherein said radiation light source provides radiation light having wavelength below 50 nm.

10. An illumination apparatus, for using in a photolithography apparatus forming an image of a reflection mask, on which a predetermined pattern is formed, on a work, the illumination apparatus comprising:

a radiation light source; and

an illumination optical system located between said radiation light source and said reflection mask, and for directing said radiation light provided from said radiation light source to predetermined illumination area on said reflection mask;

wherein said illumination optical system includes a field stop and a relay optical system forming an image of said field stop on said reflection mask as said predetermined illumination area.

11. An illumination apparatus according to claim 10, wherein said radiation light source provides radiation light having wavelength shorter than 50 nm.

12. An illumination apparatus according to claim 10, wherein said relay optical system is catoptric system.

13. A method of projecting and exposing a predetermined pattern formed on a reflection mask onto a work comprising the steps of:

providing a radiation light source;

illuminating a reflection mask on which a predetermined pattern is formed with said radiation light source by means of an illumination optical system;

projecting said pattern of said reflection mask onto a work based on reflected light from said reflection mask; and

relatively moving at least one of said reflection mask and said work;

wherein said illuminating step further comprising a step of forming an image of a field stop placed in said illumination optical system on said reflection mask.

14. A method according to claim 13:
wherein said providing step provides radiation light having wavelength shorter than 50 nm.

15. A method according to claim 14:

further comprising a step of adjusting a position of at least one optical element located along the optical path where said radiation light is directed to said field stop in order to change illuminance distribution on said reflection mask or on said work.

16. A projection exposure apparatus, for directing radiation light to a reflection mask on which a predetermined pattern is formed, and for projecting an image of said predetermined pattern on a work by said radiation light reflected by said reflection mask, the projection exposure apparatus comprising:

a radiation light source;

an illumination optical system located between said radiation light source and said reflection mask, and directing said radiation light provided from said radiation light source to said reflection mask;

a projection optical system located between said reflection mask and said work, directing said radiation light reflected by said reflection mask to an exposed substrate, and forming the image of said predetermined pattern on said exposed substrate;

wherein a position of at least one of reflection optical elements located along to the optical path of said radiation light in said illumination optical system is adjustable in order to adjust illuminance distribution of said radiation light on said exposure area.

17. A projection exposure apparatus according to claim 16,

wherein said radiation light source provides radiation light having wavelength shorter than 50 nm.

**18.** A method of projecting and exposing a predetermined pattern formed on a reflection mask onto a work comprising the steps of:

> providing a radiation light source;
> illuminating a reflection mask on which a predetermined pattern is formed with said radiation light source by means of an illumination optical system;
> projecting said pattern of said reflection mask onto a work based on reflected light from said reflection mask;
> adjusting a position of at least one optical element located along the optical path where said radiation light is directed to said field stop in order to change illuminance distribution in said exposure area on said work.

**19.** A method according to claim 18:
wherein said providing step provides radiation light having wavelength shorter than 50 nm.

Fig. 1

*IE*

*SA*

Fig. 2

From Optics 6

73B

71

73A

MCU

72B

72A

RP

To Relay Optical System 8

## Fig. 3A

72A

71a

71

72B

## Fig. 3B

72B  71  72A

**Fig. 4A**

IE   SA

**Fig. 4F**

71

72B          72A

**Fig. 4B**

IE   SA

**Fig. 4G**

71

72B          72A

**Fig. 4C**

IE   SA

**Fig. 4H**

71

72B          72A

**Fig. 4D**

SA   IE

**Fig. 4I**

71

72B          72A

**Fig. 4E**

SA   IE

**Fig. 4J**

Fig.5A

Fig.5B

Fig.5C

S

9

9A

S

9

9B

S

9

9C

Fig.5D

Fig.5E

Fig.5F